**Europäisches Patentamt**

**European Patent Office**

**Office européen des brevets**

(19)

(11) Veröffentlichungsnummer: **0 145 950**
**B1**

(12) **EUROPÄISCHE PATENTSCHRIFT**

(45) Veröffentlichungstag der Patentschrift:
**22.06.88**

(51) Int. Cl.⁴: **G 01 C 17/38, G 01 R 33/025**

(21) Anmeldenummer: **84113645.0**

(22) Anmeldetag: **12.11.84**

(54) Koppelnavigationsverfahren für Strassenfahrzeuge und Einrichtung zur Durchführung des Verfahrens.

(30) Priorität: **15.11.83 DE 3341347**

(43) Veröffentlichungstag der Anmeldung:
**26.06.85 Patentblatt 85/26**

(45) Bekanntmachung des Hinweises auf die Patenterteilung:
**22.06.88 Patentblatt 88/25**

(84) Benannte Vertragsstaaten:
**AT BE DE FR IT NL**

(56) Entgegenhaltungen:
**EP - A - 0 027 232**

**PATENTS ABSTRACTS OF JAPAN, Band 6, Nr. 175
(P-141)(1053), September 9, 1982
PATENTS ABSTRACTS OF JAPAN, Band 6, Nr. 92
(P-119)(970), May 29, 1982**

(73) Patentinhaber: **Siemens Aktiengesellschaft Berlin und München, Wittelsbacherplatz 2, D-8000 München 2 (DE)**

(72) Erfinder: **von Tomkewitsch, Romuald, Dipl.-Ing., Winklweg 8, D-8026 Ebenhausen (DE)**
Erfinder: **Thilo, Peer, Dr.-Ing., Buchhierlstrasse 19, D-8000 München 71 (DE)**

## Beschreibung

Die Erfindung bezieht sich auf ein Koppelnavigationsverfahren für Fahrzeuge, wobei mittels einer Sondenanordnung der Feldvektor des Erdmagnetfeldes gemessen und zur Bestimmung der jeweiligen Fahrtrichtung des Fahrzeugs ausgewertet wird und wobei zur Kompensation von Störeinflüssen lokaler Störmagnetfelder im Fahrzeug durch Eichmessungen ein Störfeldvektor ermittelt, gespeichert und bei den nachfolgenden Messungen jeweils von dem gemessenen Magnetfeldvektor subtrahiert wird, um den Erdfeldvektor zu erhalten. Ausserdem bezieht sich die Erfindung auf eine Einrichtung in einem Fahrzeug zur Durchführung des Navigationsverfahrens.

Als Orientierungshilfe für Fahrzeuge ist das Koppelnavigationsverfahren seit langem bekannt. Es kann entweder als autarkes Navigationssystem in den einzelnen Fahrzeugen benutzt werden (DE-OS-2 941 331) oder Bestandteil eines universellen Verkehrsleit- und Informationssystems (DE-OS-2 936 062) sein. Zur Koppelnavigation muss während der Fahrt neben der Wegstrecke auch dauernd die Fahrtrichtung gemessen werden. Am einfachsten ist die Bestimmung dieser Fahrtrichtung mit Hilfe des magnetischen Feldes der Erde durchzuführen. Zur Bestimmung des Winkels zwischen der Längsachse eines Fahrzeuges und der magnetischen Nordrichtung können die sogenannte Förstersonde oder besondere Weiterentwicklungen dieser Sonde verwendet werden. Solche Sonden sind in der DE-OS-2 946 640 und zugehörige Auswerteschaltungen sind in der DE-OS-2 949 815 beschrieben.

Störend auf die Bestimmung der Erdfeldrichtung wirken sich magnetische Störfelder des Fahrzeugs selbst aus, die im wesentlichen von remanent magnetischen Karosserieteilen herrühren. Auch elektrische Ströme durch die Fahrzeugkarosserie haben magnetische Felder zur Folge. Zur Kompensation dieser Störfelder kann man die Tatsache nutzen, dass der Erdfeldvektor bei Drehung des Fahrzeugs um 360° mit seiner Spitze einen Kreis beschreiben muss. Diesen Kreis kann man bestimmen, in dem man mit dem Fahrzeug einmal im Kreis fährt und dabei den Verlauf des gemessenen Magnetfeldvektors aufzeichnet. Liegt der gemessene Magnetfeldvektor mit seinem Fusspunkt nicht auf dem Mittelpunkt dieses Kreises, so ist ein Störfeld vorhanden, dessen Betrag und Richtung durch den Vektor zwischen dem erwähnten Fusspunkt und dem Kreismittelpunkt beschrieben wird (DE-OS-3 123 180). Es ist auch nicht unbedingt notwendig, zur Gewinnung des Störfeldvektors einen vollständigen Kreis zu fahren, da die geometrische Figur auch bereits aus einem mehr oder weniger grossen Bogen berechnet werden kann (europäische Offenlegungsschrift 0 041 892). Durch laufende Messung während der Fahrt kann der Störfeldvektor auch ständig aktualisiert werden, um so auch langsame Änderungen des Störmagnetfeldes zu berücksichtigen. Dabei wird die Tatsache genutzt, dass sich das magnetische Störfeld eines Fahrzeuges beim Durchfahren von Kurven mit dem Fahrzeug dreht, während das magnetische Feld der Erde natürlich seine Richtung beibehält.

Eine Eichfahrt, die einen Kreis ganz oder teilweise beschreiben soll, kann deshalb in der Regel unterbleiben. Solange das fahrzeugeigene Störfeld sich nicht verändert hat, kann der zuletzt gespeicherte Störfeldvektor auch nach einem längeren Stillstand weiter zur Korrektur verwendet werden. Startet jedoch ein Fahrzeug nach längerer Parkdauer, während der sein die Magnetsonde beeinflussendes remanentes Magnetfeld sich z.B. durch Temperatureinflüsse geändert hat, zu einer Fahrt auf einer Strasse ohne signifikante Kurven, so unterbleibt eine Störfeldkompensation und der Winkelmessfehler ist entsprechend gross.

Noch kritischer ist es, wenn am Fahrzeug beim Start oder während der Fahrt Änderungen vorgenommen werden, die eine Verlagerung des Störfeldes bewirken. Das Öffnen des Schiebedaches oder das Einschalten eines Stromkreises, z.B. zur Heckscheibenbeheizung, können eine solche Wirkung haben. Bewegt sich dabei das Fahrzeug auf einer längeren geraden Strecke, so wird die automatische Anpassung des Störfeldvektors, die auf das Durchfahren von Kurven angewiesen ist, nicht durchgeführt, so dass die Missweisung der Navigationseinrichtung erheblich sein kann. Es wäre zwar theoretisch möglich, bei jedem Fahrzeug einen Einbauort für die Sonde durch umfangreiche Messungen zu ermitteln, an dem alle gewöhnlich auftretenden Störfeldveränderungen sich bezüglich der Sonde weitgehend neutral verhalten, doch hätte dies in jedem Einzelfall einen erheblichen, unvertretbaren Aufwand zur Folge.

Daneben kommt es auch vor, dass einzelne Messwerte stark fehlerbehaftet sind, weil das magnetische Feld der Erde lokal durch Einflüsse ausserhalb des Fahrzeuges, z.B. von stromführenden Leitungen oder von grossen Eisenmassen auf benachbarten Fahrzeugen bzw. Gebäuden, verzerrt wird. Eine automatische Störfeldkompensation führt an solchen Stellen zu falschen Ergebnissen und damit evtl. sogar zu einer Vergrösserung des Messfehlers.

Aufgabe der Erfindung ist es, ein Navigationsverfahren der eingangs genannten Art und eine Einrichtung zur Durchführung dieses Verfahrens mit einer Störfeldkompensation zu versehen, bei der Änderungen von Störeinflüssen schnell erkannt werden und eine Weiterverwendung falscher Korrekturwerte verhindert wird. Dieses Verfahren soll so ausgestaltet werden können, dass bei bleibenden Änderungen des Störmagnetfeldes eine schnelle Korrektur des Störfeldvektors automatisch durchführbar ist und dass bei vorübergehenden Feldänderungen ebenfalls eine Fehlkompensation vermeidbar ist.

Erfindungsgemäss wird diese Aufgabe dadurch gelöst, dass mindestens zwei Magnetfeldsonden im Fahrzeug räumlich getrennt angeordnet werden, dass für diese jeweils eigene Störfeldvektoren ermittelt und gespeichert werden, dass bei jedem Messvorgang mit jeder Magnetfeldsonde ein Magnetfeldvektor gemessen und mit dem zugehörigen Störfeldvektor zur Ermittlung des Erdfeldvektors miteinander nach Betrag und Richtung verglichen werden und dass bei signifikanter Abweichung der ermittelten Erdfeldvektoren voneinander ein Änderungssignal erzeugt wird.

Mit dem erfindungsgemässen Verfahren werden also durch die Verwendung von mindestens zwei Magnetfeldsonden schnell Änderungen von Störfeldern festgestellt. Entsprechende Signale können eine schnelle Korrektur der Störfeldkompensation einleiten. Das erfindungsgemässe Verfahren beruht darauf, dass mit zwei Magnetfeldsonden inhomogene Magnetfelder, deren Quellen in der Nähe der Magnetfeldsonden zu suchen sind, vom homogenen Erdfeld unterschieden werden können. Denn die parallel verlaufenden Feldlinien des Erdmagnetfeldes durchsetzen die Sonden, auch wenn sie innerhalb eines Fahrzeuges voneinander räumlich getrennt angeordnet sind, in gleicher Weise, während die Feldlinien eines im Fahrzeug oder neben dem Fahrzeug erzeugten Störfeldes die beiden Sonden bei räumlicher Entfernung voneinander unterschiedlich durchsetzen. Eine Änderung des Störfeldes führt deshalb zu einer Abweichung der gemessenen Werte und bei Beibehaltung der ursprünglich ermittelten Störfeldvektoren als Korrekturwerten auch zu einer Änderung der errechneten Erdfeldvektoren. Mit der Verwendung von zwei Magnetfeldsonden nach der Erfindung kann man einen Effekt erreichen, der mit dem räumlichen Sehen oder dem Stereoeffekt beim Hören vergleichbar ist.

Nachdem mit dem erfindungsgemässen Verfahren eine Änderung des Störfeldes erkannt ist, können auch geeignete Massnahmen automatisch eingeleitet werden, um schnell eine Korrektur der Messwerte, d.h., eine Neuberechnung der Störfeldvektoren herbeizuführen oder zumindest eine Falschanzeige zu verhindern. So ist in einer vorteilhaften Weiterbildung der Erfindung vorgesehen, dass der letzte als richtig festgestellte Erdfeldvektor mit den gemessenen Magnetfeldvektoren der beiden Magnetfeldsonden verglichen wird und dass durch Differenzbildung für die beiden Magnetfeldsonden neue Störfeldvektoren errechnet werden. Dabei geht dieses Verfahren von der Annahme aus, dass der zuletzt übereinstimmend festgestellte Erdfeldvektor mit grosser Wahrscheinlichkeit auch bei der neuen Messung noch für das Fahrzeug Gültigkeit hat und dass sich lediglich das Störfeld im Fahrzeug geändert hat. Die so rückgerechneten neuen Störfeldvektoren können dann für die nächsten Messungen verwendet werden. Ergeben diese Messungen von beiden Magnetfeldsonden dann wieder übereinstimmende Ergebnisse bei den Erdfeldvektoren, so kann die Korrektur als erfolgreich abgeschlossen werden. Die neuen Störfeldvektoren können dann anstelle der ursprünglichen Störfeldvektoren beibehalten werden.

Ergibt sich jedoch nach einem oder wenigen Messzyklen, dass auch die rückgerechneten neuen Störfeldvektoren wieder zu falschen, nämlich zu nicht übereinstimmenden Ergebnissen bei der Ermittlung der Erdfeldvektoren führen, so kann dies ein Zeichen dafür sein, dass ein vorübergehender Störfeldeinfluss vorhanden war, beispielsweise durch das Passieren eines mit Eisen beladenen Lastwagens. In diesem Fall müsste nach einer kurzen Zeit bzw. Fahrstrecke dieser vorübergehende Störeinfluss aufhören zu wirken, so dass die ursprünglichen Störfeldvektoren wieder Gültigkeit haben. Es werden deshalb zweckmässigerweise in diesem Fall nach einer vorgegebenen Zeitspanne oder Fahrstrecke die ursprünglichen Störfeldvektoren wieder zur Berechnung des Erdfeldvektors bei beiden Magnetfeldsonden eingesetzt. Für den in der Zwischenzeit zurückgelegten Weg wird zweckmässigerweise ein zwischen der zuletzt übereinstimmend ermittelten Fahrtrichtung und der neu wieder als übereinstimmend ermittelten Fahrtrichtung interpoliert wird, um so eine gute Annäherung an den tatsächlich zurückgelegten Weg nach Länge und Richtung zu erreichen.

Führen jedoch die beiden erwähnten automatischen Korrekturmassnahmen nicht zum Erfolg, was beispielsweise bei einer schnellen Änderung des Störfeldes (z.B. Öffnen des Schiebedaches) und gleichzeitiger starker Richtungsänderung der Fall sein kann, so ist es weiterhin zweckmässig, ein Hinweissignal auszugeben, welches beispielsweise den Fahrzeugführer zu einer Korrekturfahrt, beispielsweise Durchfahren mehrerer Kurven oder Fahren um einen Häuserblock, veranlasst. Damit kann dann erreicht werden, dass die eingangs beschriebene automatische Ermittlung des Störfeldvektors wieder zum Zuge kommt und richtige Messwerte liefert. In jedem Fall wird dabei verhindert, dass nicht mehr gültige Störfeldvektoren über längere Zeit die Koppelnavigation beeinflussen und damit die Genauigkeit der gesamten Zielführung verschlechtern.

Vorteilhafte Ausgestaltungen einer Einrichtung zur Durchführung des erfindungsgemässen Verfahrens sind in den Unteransprüchen angegeben.

Die Erfindung wird nachfolgend an Ausführungsbeispielen anhand der Zeichnung näher erläutert. Es zeigt

Fig. 1 das Koppelnavigationsverfahren anhand einer schematisch dargestellten Wegstrecke,

Fig. 2 das Prinzip der Störfeldkorrektur in schematischer Darstellung,

Fig. 3 und 4 zwei mögliche Anordnungen von zwei Magnetfeldsonden in einem Fahrzeug,

Fig. 5 die Wirkung eines fahrzeugeigenen Störfeldes auf zwei räumlich getrennte Magnetfeldsonden in schematischer Darstellung,

Fig. 6 die Wirkung einer ausserhalb des Fahrzeugs liegenden Störung des Erdmagnetfeldes auf zwei im Fahrzeug angeordnete Magnetfeldsonden,

Fig. 7 eine schematische Darstellung der Ermittlung des Erdfeldvektors mit zwei räumlich getrennten Magnetfeldsonden,

Fig. 8 ein Blockschaltbild einer für das erfindungsgemässe Verfahren verwendbaren Navigationseinrichtung.

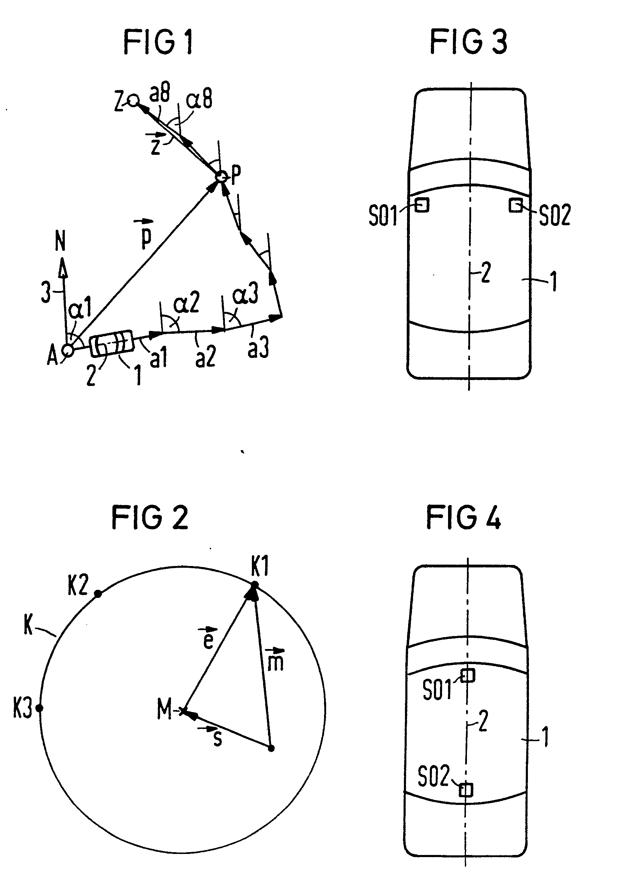

Fig. 1 zeigt das an sich bekannte Prinzip der Koppelnavigation mittels Messung des Erdmagnetfeldes. Ein Fahrzeug 1 bewegt sich von einem Anfangspunkt A bis zu einem Zielpunkt Z, wobei der zurückzulegende Weg in lauter kleinen Abschnitten a1, a2 usw. gemessen wird. Die Streckenlänge dieser einzelnen Abschnitte kann ohne weiteres mittels eines vorhandenen Wegmessers (Tachometer) ermittelt werden. Bei jedem dieser Abschnitte a1, a2 usw. besitzt die Fahrzeuglängsachse 2 einen bestimmten Winkel $\alpha 1$, $\alpha 2$ usw. gegenüber der magnetischen Nordrichtung 3. Dieser Winkel lässt sich durch Messung des Erdfeldvektors $\vec{e}$ berechnen. Durch vektorielle Addition aller zurückgelegten Wegstrecken nach Betrag und Richtung lässt sich dann die aktuelle Position gegenüber dem Anfangspunkt A, gekennzeichnet durch den Vektor $\vec{p}$, bzw. die Entfernung zu einem angestrebten Ziel Z, gekennzeichnet durch den Vektor $\vec{z}$, nach Betrag und Richtung feststellen.

Die Winkelmessung erfolgt durch ständige Messung des Erdfeldvektors $\vec{e}$. Dabei ist jedoch, wie eingangs erwähnt, nach Fig. 2 jeder Messwert mit einem Störfeldvektor $\vec{s}$ behaftet. Der gemessene Magnetfeldvektor $\vec{m}$ setzt sich also aus dem tatsächlichen Erdfeldvektor $\vec{e}$ und dem Störfeldvektor $\vec{s}$ vektoriell zusammen. Da der Erdfeldvektor $\vec{e}$ bei einer Drehung des Fahrzeuges um 360° mit seiner Spitze einen Kreis K um den Mittelpunkt M beschreibt, kann der Störvektor in an sich bekannter Weise durch Errechnung des Kreismittelpunktes M ermittelt werden. Theoretisch kann der Mittelpunkt M des Kreises K mit drei Messwerten, beispielsweise den Messpunkten K1, K2 und K3 bestimmt werden. Es genügt also bereits das Durchfahren eines bestimmten Kreisbogens, um den Störvektor $\vec{s}$ festzustellen. Zur Bestimmung des Erdfeldvektors $\vec{e}$ muss der Navigationsrechner im Fahrzeug dann lediglich vom gemessenen Vektor $\vec{m}$ den Störfeldvektor $\vec{s}$ subtrahieren.

In der Praxis benötigt man mehr als drei Messpunkte zur Bestimmung des Kreismittelpunktes M, weil jeder Messpunkt fehlerbehaftet ist. Deshalb muss ein Fahrzeug zur automatischen Störfeldkompensation mehrere Kurven durchfahren. Fährt aber ein Fahrzeug nach einer wesentlichen Änderung seines Störfeldes, beispielsweise nach dem Öffnen oder Schliessen des Schiebedaches, eine längere gerade Strecke, so wird der neue Wert des Störfeldvektors nicht automatisch berechnet, und die Korrektur mit dem alten Störfeldvektor führt zu falschen Ergebnissen. Deshalb wird beim erfindungsgemässen Verfahren eine Anordnung mit mindestens zwei im Fahrzeug räumlich getrennt angeordneten Magnetfeldsonden verwendet. Mögliche Anordnungen zeigen die Fig. 3 und 4. In Fig. 3 ist das Fahrzeug 1 in Draufsicht dargestellt. Die beiden Magnetfeldsonden SO1 und SO2 sind symmetrisch zur Fahrzeuglängsachse, und zwar zu beiden Seiten mit gleichem Abstand von der Längsachse angeordnet. Beispielsweise sind sie in an sich bekannter Weise an der Innenseite des Fahrzeugdaches befestigt.

Fig. 4 zeigt eine etwas andere Anordnung der beiden Sonden. In diesem Fall sind die Magnetfeldsonden SO1 und SO2 beide auf der Fahrzeuglängsachse 2 des Fahrzeugs 1, jedoch in Richtung dieser Längsachse gegeneinander versetzt, angeordnet. Die symmetrische Anordnung zur Fahrzeuglängsachse ist jedoch nicht in jedem Fall erforderlich. Wichtig ist vor allem, dass beide Sonden zueinander einen räumlichen Abstand besitzen, so dass sich Änderungen des fahrzeugeigenen Störfeldes unterschiedlich in beiden Sonden auswirken.

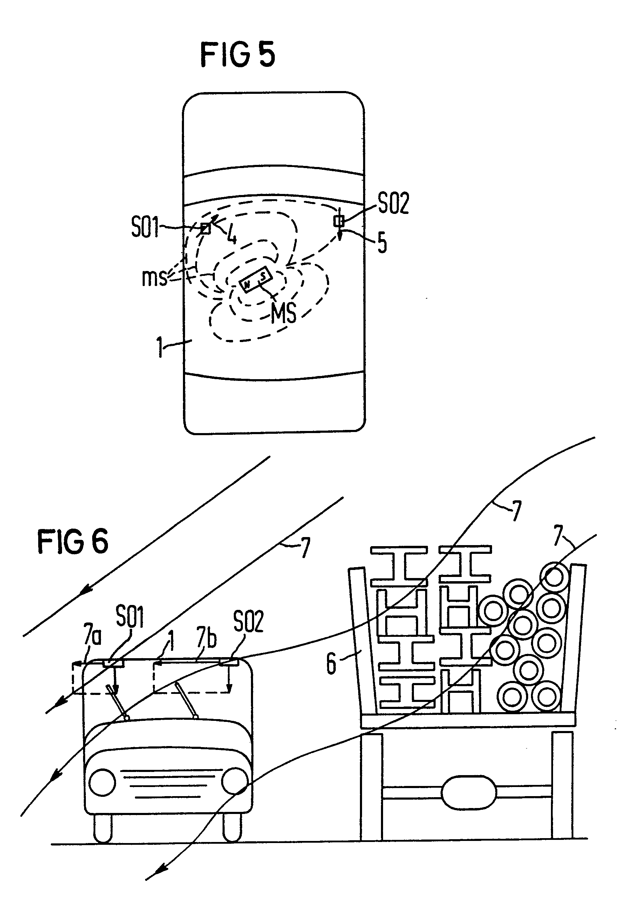

Fig. 5 zeigt schematisch die Wirkung eines fahrzeugeigenen Störfeldes, das von remanenten Magnetfeldern im Dach des Fahrzeuges 1 bzw. von hartmagnetischen Teilen ausgeht. Die Quellen dieser remanenten Magnetfelder sind schematisch zu einem Störfeldmagneten MS zusammengefasst und mit den dazugehörigen Feldlinien ms dargestellt. Diese Feldlinien ms verlaufen in der bekannten Weise im Fahrzeugdach und durchqueren die Sonde SO1 in Richtung des Pfeiles 4, die Sonde SO2 dagegen in Richtung des Pfeiles 5. Ausserdem weisen sie in den beiden Sonden unterschiedliche Feldstärken auf. Verändert sich nun die Position und Stärke des Störfeldmagneten MS, so wirkt sich das wegen der Inhomogenität des Störfeldes auf die Sonden SO1 und SO2 in unterschiedlicher Weise aus.

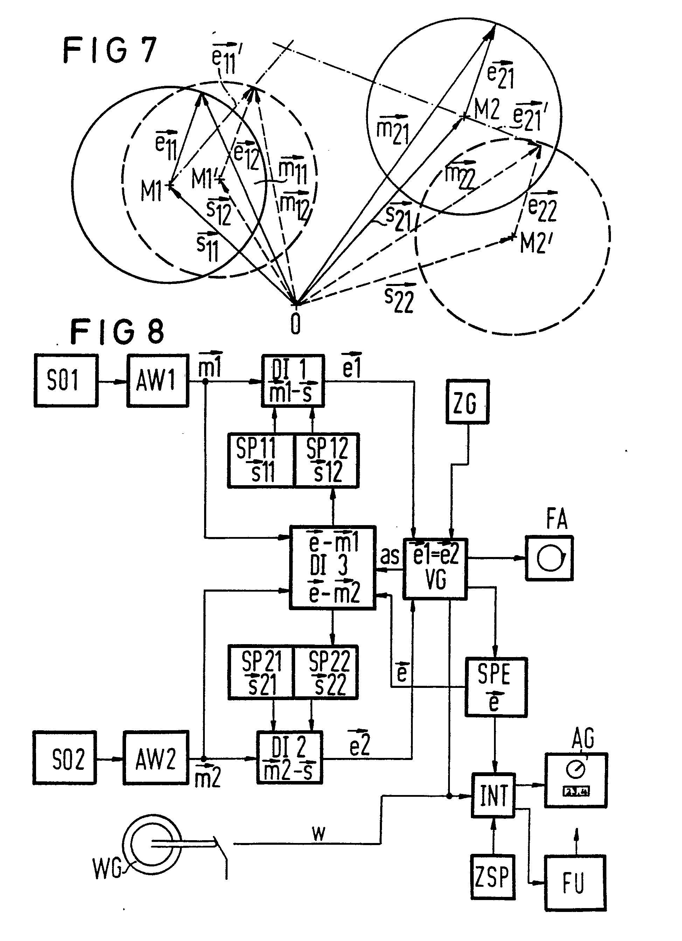

In Fig. 7 sind die entsprechenden Feldvektoren dargestellt. Legt man einen bestimmten ersten Zustand des Störfeldmagneten zugrunde, so bewirkt er für die Sonde SO1 den Störvektor $\vec{s}_{11}$ und gegenüber der Sonde SO2 einen Störvektor $\vec{s}_{21}$. Bei einer bestimmten Fahrzeugstellung wird bezüglich eines Systemnullpunktes 0 mit der Sonde SO1 ein Magnetfeldvektor $\vec{m}_{11}$ gemessen, der mit Hilfe des ursprünglich ermittelten und gespeicherten Störvektors $\vec{s}_{11}$ korrigiert wird und dann den tatsächlichen Erdfeldvektor $\vec{e}_{11}$ ergibt. Mit der Sonde SO2 wird gleichzeitig ein Magnetfeldvektor $\vec{m}_{21}$ gemessen, welcher mit dem Störfeldvektor $\vec{s}_{21}$ korrigiert wird und den Erdfeldvektor $\vec{e}_{21}$ ergibt. Solange die Störfeldvektoren $\vec{s}_{11}$ und $\vec{s}_{21}$ richtig sind, ergibt die Korrektur in beiden Fällen den gleichen Erdfeldvektor, die Vektoren $\vec{e}_{11}$ und $\vec{e}_{21}$ müssen also nach Betrag und Richtung gleich sein.

Ändert sich aber das fahrzeugeigene Störfeld, d.h. der in Fig. 5 dargestellte Störfeldmagnet MS ändert sich in der Position und/oder seiner Richtung, so ergeben sich neue Störfeldvektoren $\vec{s}_{12}$ und $\vec{s}_{22}$. Das bedeutet aber, dass der Kreismittelpunkt für den Erdfeldvektor von M1 nach M1' bzw. von M2 nach M2' wandert. Berechnet man nun die Erdfeldvektoren aus den neuen Messwerten $\vec{m}_{12}$ und $\vec{m}_{22}$ unter Verwendung der alten Störfeldvektoren $\vec{s}_{11}$ und $\vec{s}_{21}$, so ergeben sich für die beiden Sonden falsche Erdfeldvektoren $\vec{e}_{11}'$ und $\vec{e}_{21}'$, die nach Betrag und Richtung divergieren. Die Sonden beginnen scheinbar zu «schielen», während sich das homogene Erdmagnetfeld aber in Wirklichkeit nicht verändert hat. Eine ähnliche Wirkung haben Einflüsse von ausserhalb, wie sie in Fig. 6 angedeutet sind. Fährt beispielsweise neben dem Fahrzeug 1 ein mit Eisenträgern beladener Lastwagen 6, so werden die Feldlinien 7 des Erdmagnetfeldes unterschiedlich ausgelenkt. Es ergeben sich unterschiedliche Komponenten 7a und 7b eines inhomogenen Magnetfeldes in der Ebene, in der die Sonden SO1 und SO2 angeordnet sind.

Die Divergenz der falschen Erdfeldvektoren $\vec{e}_{11}'$ und $\vec{e}_{21}'$ (Fig. 7) wird von einer Vergleichseinrichtung sofort erkannt und ausgewertet. Da zunächst anzunehmen ist, dass es sich um eine länger andauernde Veränderung des fahrzeugeigenen Störfeldes (Störfeldmagnet MS) gemäss Fig. 5, z.B. durch einen eingeschalteten Stromkreis, handelt, werden sofort neue Störvektoren $\vec{s}_{12}$ und $\vec{s}_{22}$ berechnet. Dabei wird von der Annahme ausgegangen, dass sich das Fahrzeug in unveränderter Richtung fortbewegt, d.h., dass $\vec{e}_{11} = \vec{e}_{12}$ und $\vec{e}_{21} = \vec{e}_{22}$. Da Kraftfahrzeuge im Zeitraum weniger Sekunden tatsächlich nur sehr selten ihre Fahrtrichtung markant ändern, ist diese Annahme in den meisten Fällen zulässig. Von den neuen, gemessenen Magnetfeldvektoren $\vec{m}_{12}$ und $\vec{m}_{22}$ werden die zuletzt als richtig erkannten Erdfeldvektoren $\vec{e}_{12}$ und $\vec{e}_{22}$ subtrahiert. Aus dieser Rechnung ergeben sich die neuen Störfeldvektoren $\vec{s}_{12}$ und $\vec{s}_{22}$ (Fig. 7). Wäre die Annahme, dass sich das Fahrzeug im wesentlichen in unveränderter Richtung fortbewegt, nicht richtig, so könnte bei einer starken Richtungsänderung des Fahrzeugs ohnehin eine Neuberechnung bzw. Korrektur der Störfeldvektoren stattfinden.

In den nächsten Sekunden werden die weiteren Erdfeldvektoren $\vec{e}_{1i}$ und $\vec{e}_{2i}$ mit Hilfe der neu bestimmten Störfeldvektoren $\vec{s}_{12}$ und $\vec{s}_{22}$ berechnet. Ergeben sich dann wieder parallele, also nach Betrag und Richtung gleiche Erdfeldvektoren $\vec{e}_{1i}$ und $\vec{e}_{2i}$, so hatte die Korrekturmassnahme Erfolg und die neuen Störfeldvektoren $\vec{s}_{12}$ und $\vec{s}_{22}$ können für die weitere Navigation im Speicher verbleiben. Die Zeit, die bis zur Berechnung der neuen Störfeldvektoren abzuwarten ist, kann nach Erfahrungswerten vorgegeben werden. Sie hängt beispielsweise davon ab, wie lange das Öffnen oder Schliessen eines Schiebedachs dauert, womit der neue Zustand des Störfeldmagneten MS hergestellt wird.

Divergieren aber die mit den neuen Störfeldvektoren $\vec{s}_{12}$ und $\vec{s}_{22}$ berechneten Erdfeldvektoren $\vec{e}_{1i}$ und $\vec{e}_{2i}$ nach der erwähnten Korrekturmassnahme wieder, so lag der Grund für ein inhomogenes Feld höchstwahrscheinlich ausserhalb des Fahrzeuges. Es hat sich also gemäss Fig. 6 um eine vorübergehende Störung des Erdmagnetfeldes gehandelt. In diesem Fall versucht die Fahrzeugeinrichtung nach einer bestimmten Zeit oder Fahrstrecke wieder mit den noch gespeicherten ursprünglichen Störfeldvektoren $\vec{s}_{11}$ und $\vec{s}_{21}$ weiter. Lag tatsächlich der Fall von Fig. 6 vor, so ergeben sich danach wieder richtige Messwerte, d.h. Erdfeldvektoren $\vec{e}_{1i}$ und $\vec{e}_{2i}$, die nach Betrag und Richtung übereinstimmen. Da die fehlerhafte Richtungsbestimmung bei lokalen Erdfeldverzerrungen im allgemeinen nur für eine relativ kurze Fahrstrecke bzw. Zeit wirksam ist, ist der Navigationsfehler zu tolerieren. Man kann diesen Navigationsfehler aber auch noch dadurch verringern, dass man zwischen den Fahrtrichtungen vor und nach der Störung interpoliert.

Bei der Einleitung geeigneter Korrekturmassnahmen nach dem Auftreten des Änderungssignals kann berücksichtigt werden, dass unterschiedliche Ursachen für die Änderung des Störfeldes auch unterschiedliche Verhaltensmuster der Störfeldvektoren auslösen. So ist das Einschalten eines Stromkreises in Bruchteilen einer Sekunde abgeschlossen, so dass in einem solchen Fall der Störfeldveränderung der neue Störfeldvektor sofort neu berechnet werden kann.

Das Öffnen bzw. Schliessen des Schiebedaches dauert mindestens mehrere Sekunden. Dabei kann es zweckmässig sein, während dieser Zeit die Störfeldvektoren in Abständen jeweils neu zu berechnen und alle Werte zu speichern. Es ergibt sich dabei ein bestimmter Verlauf der Störfeldvektoren bzw. der danach jeweils berechneten Erdfeldvektoren. Durch Vergleich der nacheinander ermittelten Störfeldvektoren lässt sich wiederum automatisch feststellen, wenn die Störfeldänderung abgeschlossen ist, so dass die dann unter Verwendung von vorhergehenden, als richtig erkannten Erdfeldvektoren berechneten neuen Störfeldvektoren als Grundlage für die weitere Kompensation gespeichert und verwendet werden können.

Eine vorübergehende Beeinflussung des Erdmagnetfeldes durch eine ausserhalb des Fahrzeugs liegende Störquelle hat wiederum einen anderen Verlauf der in obiger Weise neu berechneten Störfeldvektoren zur Folge. Auch das kann erkannt und zu einer entsprechenden Korrektur bzw. zur erneuten Verwendung der ursprünglichen Störfeldvektoren ausgewertet werden.

Fig. 8 zeigt das Blockschaltbild einer Koppelnavigationseinrichtung zur Durchführung des beschriebenen Korrekturverfahrens. Die beiden getrennt angeordneten Magnetfeldsonden SO1 und SO2 besitzen jeweils eine Auswerteeinrichtung AW1 und AW2, mit deren Hilfe die elektrischen Sonden Signale in bekannter Weise in Koordinaten eines Magnetfeldvektors umgerechnet werden. Am Ausgang dieser beiden Auswerteeinrichtungen erscheinen deshalb die Messwerte für einen Magnetfeldvektor $\vec{m}_1$ und einen Magnetfeldvektor $\vec{m}_2$. Diese Messwerte werden jeweils differenzbildenden Rechenwerken DI1 und DI2 zugeführt, welche ausserdem jeweils aus einem Korrekturwertspeicher SP11 bzw. SP21 die früher ermittelten Störfeldvektoren $\vec{s}_{11}$ bzw. $\vec{s}_{21}$ erhalten. Die vektorielle Differenz aus dem gemessenen Magnetfeldvektor $\vec{m}_1$ und dem Störfeldvektor $\vec{s}_{11}$ ergibt den Erdfeldvektor $\vec{e}_1$, während die Differenz aus dem gemessenen Magnetfeldvektor $\vec{m}_2$ und dem Störfeldvektor $\vec{s}_{21}$ den Erdfeldvektor $\vec{e}_2$ ergibt. Solange die Störfeldverhältnisse gleich bleiben und die Störfeldvektoren zutreffend sind, stimmen die ermittelten Erdfeldvektoren $\vec{e}_1$ und $\vec{e}_2$ nach Betrag und Richtung überein. Diese Erdfeldvektoren werden beide einer Vergleichseinrichtung VG zugeführt; wird dort die Übereinstimmung festgestellt, so wird der ermittelte Erdfeldvektor $\vec{e} = \vec{e}_1 = \vec{e}_2$ über einen Zwischenspeicher SPE an eine Integrierschaltung INT weitergegeben. Diese Integrierschaltung erhält von einem Weggeber WG den jeweiligen Messwert W für die zurückgelegte Fahrtstrecke, so dass der jeweils zurückgelegte Weg nach Betrag und Richtung im Integrator INT vorliegt und von einem im Zielspeicher ZSP gespeicherten Zielvektor subtrahiert werden kann. Das Ergebnis, ein neuer Zielvektor nach Betrag und Richtung, kann dann im Anzeigegerät AG angezeigt werden.

Ergibt jedoch der Vergleich der Erdfeldvektoren $\vec{e}_1$ und $\vec{e}_2$ in der Vergleichseinrichtung VG keine Übereinstimmung, so wird ein Änderungssignal as an eine Subtrahiereinrichtung DI 3 gegeben, welche eine sofortige Neuberechnung der Störfeldvektoren durchführt. In dieser Subtrahiereinrichtung DI 3 wird für die Sonde SO1 ein Störfeldvektor $\vec{s}_{12}$ aus dem zuletzt gespeicherten Erdfeldvektor $\vec{e}$ und dem Messwert $\vec{m}_1$ berechnet und im Speicher SP12 hinterlegt. In gleicher Weise wird für die Sonde SO2 ein neuer Störfeldvektor $\vec{s}_{22}$ als Differenz aus dem zuletzt gültigen Erdfeldvektor $\vec{e}$ und dem neuen Messwert $\vec{m}_2$ gebildet und im Speicher SP22 gespeichert. Dieser Vorgang kann durch einen Zeitgeber ZG um eine bestimmte Zeit oder durch ein Signal vom Weggeber WG um eine bestimmte Fahrtstrecke verzögert werden, so dass die Änderung des Störfeldes bei der Neuberechnung bereits abgeschlossen ist.

Danach wird die Bestimmung des Erdfeldvektors für eine bestimmte Zeit oder eine bestimmte Wegstrecke mit den neuen Störfeldvektoren $\vec{s}_{12}$ und $\vec{s}_{22}$ durchgeführt. Ergibt sich dann nach einer bestimmten Zeit und nach einer gewissen Mittelwertbildung streuender Einzelmesswerte wieder eine Übereinstimmung der Erdfeldvektoren $\vec{e}_1$ und $\vec{e}_2$ im Vergleicher VG, so war die Korrektur erfolgreich und die neu berechneten Störfeldvektoren $\vec{s}_{12}$ und $\vec{s}_{22}$ können in den Speicher SP11 bzw. SP21 übernommen und der weiteren Navigation zugrundegelegt werden. Ergibt sich jedoch eine solche Übereinstimmung auch dann nicht, so wird in der oben beschriebenen Weise nach einer vorgegebenen Zeit wieder eine Berechnung unter Verwendung der ursprünglichen Störfeldvektoren $\vec{s}_{11}$ und $\vec{s}_{21}$ durchgeführt. Bleibt auch das erfolglos, so kann über eine Fehleranzeige FA dem Fahrer ein Hinweis gegeben werden, dass die Navigation nicht mehr mit hinreichender Genauigkeit arbeitet und dass er durch einige Kurvenfahrten oder durch eine Kreisfahrt eine automatische Neuberechnung der Störfeldvektoren gemäss Fig. 2 ermöglichen sollte.

Soll die aktuelle Position des Fahrzeuges einer entfernteren Betriebsleitzentrale oder Einsatzleitzentrale übermittelt werden, so können die Istkoordinaten in ebenfalls bekannter Weise über ein Funkgerät FU übertragen werden.

Die Funktionen der beiden Auswerteeinrichtungen AW1 und AW2 können gegebenenfalls von ein und demselben Schaltkreis durchgeführt werden. In gleicher Weise können auch die übrigen Funktionen der Navigationseinrichtung von geeigneten Schaltungsbausteinen, insbesondere auch von einem Mikroprozessor, durchgeführt werden.

## Patentansprüche

1. Koppelnavigationsverfahren für Strassenfahrzeuge, wobei mittels einer Sondenanordnung der Feldvektor des Erdmagnetfeldes gemessen und zur Bestimmung der jeweiligen Fahrtrichtung des Fahrzeuges ausgewertet wird und wobei zur Kompensation von Störeinflüssen lokaler Störmagnetfelder im Fahrzeug durch Eichmessungen ein Störfeldvektor ermittelt, gespeichert und bei den nachfolgenden Messungen jeweils von dem gemessenen Magnetfeldvektor subtrahiert wird, um den Erdfeldvektor zu erhalten, dadurch gekennzeichnet, dass mindestens zwei Magnetfeldsonden (SO1, SO2) im Fahrzeug (1) räumlich getrennt angeordnet werden, dass für diese (SO1, SO2) jeweils eigene Störfeldvektoren ($\vec{s}_{11}$, $\vec{s}_{21}$) ermittelt und gespeichert werden, dass bei jedem Messvorgang mit jeder Magnetfeldsonde (SO1, SO2) ein Magnetfeldvektor ($\vec{m}_1$, $\vec{m}_2$) gemessen und mit dem zugehörigen Störfeldvektor ($\vec{s}_{11}$, $\vec{s}_{21}$) zur Ermittlung des Erdfeldvektors ($\vec{e}_1$, $\vec{e}_2$) korrigiert wird, dass die getrennt ermittelten Erdfeldvektoren ($\vec{e}_1$, $\vec{e}_2$) miteinander nach Betrag und Richtung verglichen werden und dass bei signifikanter Abweichung der ermittelten Erdfeldvektoren voneinander ein Änderungssignal (as) erzeugt wird.

2. Verfahren nach Anspruch 1, dadurch gekennzeichnet, dass nach Erzeugung des Änderungssignals (as) neue Störfeldvektoren ($\vec{s}_{12}$, $\vec{s}_{22}$) als Differenzen zwischen den neu gemessenen Magnetfeldvektoren ($\vec{m}_1$, $\vec{m}_2$) und dem zuletzt übereinstimmend ermittelten Erdfeldvektor ($\vec{e}$) errechnet werden.

3. Verfahren nach Anspruch 2, dadurch gekennzeichnet, dass der Erdfeldvektor über eine vorbestimmte Zeit und/oder eine vorbestimmte Wegstrecke unter Verwendung der neu berechneten Störfeldvektoren ($\vec{s}_{12}$, $\vec{s}_{22}$) ermittelt wird.

4. Verfahren nach Anspruch 3, dadurch gekennzeichnet, dass bei erneutem Divergieren der mit Hilfe der neu errechneten Störfeldvektoren ($\vec{s}_{12}$, $\vec{s}_{22}$) ermittelten Erdfeldvektoren ($\vec{e}_1$, $\vec{e}_2$) für eine bestimmte Zeit eine Korrektur der gemessenen Magnetfeldvektoren mit Hilfe der ursprünglichen Störfeldvektoren ($\vec{s}_{11}$, $\vec{s}_{21}$) durchgeführt wird.

5. Verfahren nach Anspruch 3 oder 4, dadurch gekennzeichnet, dass bei erneutem Divergieren der unter Zugrundelegung sowohl der alten als auch der neuen Störfeldvektoren ($\vec{s}_{11}$, $\vec{s}_{21}$; $\vec{s}_{12}$, $\vec{s}_{22}$) errechneten Erdfeldvektoren eine Anzeigeeinrichtung (FA) betätigt wird.

6. Verfahren nach einem der Ansprüche 1 bis 5, dadurch gekennzeichnet, dass mehrmals hintereinander neue Störfeldvektoren unter Verwendung von vorhergehend ermittelten und gespeicherten Erdfeldvektoren berechnet und gespeichert werden und dass aus dem Verhaltensmuster der Störfeldvektoren die Art der Störfeldänderung erkannt und ausgewertet wird.

7. Verfahren nach einem der Ansprüche 1 bis 4, dadurch gekennzeichnet, dass für die während des Auftretens eines Änderungssignals (as) zurückgelegte Wegstrecke ein mittlerer Erdfeldvektor zugrundegelegt wird, der als Mittelwert aus den übereinstimmenden Erdfeldvektoren ($\vec{e}_1$, $\vec{e}_2$) vor und nach dem Auftreten des Änderungssignals ermittelt wird.

8. Verfahren nach einem der Ansprüche 1 bis 6, dadurch gekennzeichnet, dass für die während des Auftretens des Änderungssignals zurückgelegte Wegstrecke ein Erdfeldvektor durch Interpolation aus den übereinstimmend gewonnenen Erdfeldvektoren vor und nach dem Auftreten des Änderungssignals ermittelt wird.

9. Einrichtung an einem Fahrzeug zur Durchführung des Verfahrens nach einem der Ansprüche 1 bis 8, dadurch gekennzeichnet, dass in dem Fahrzeug (1) zwei Magnetfeldsonden (SO1, SO2) räumlich getrennt angeordnet sind, dass die Ausgangssignale beider Magnetfeldsonden (SO1; SO2) zusammen mit den Ausgangssignalen von Störvektorspeichern (SP11, SP21) jeweils einem Differenzbildner (DI1, DI2) zugeführt sind, deren die Erdfeldvektoren ($\vec{e}_1$, $\vec{e}_2$) führenden Ausgänge an den Eingängen einer Vergleichseinrichtung (VG) anliegen.

10. Einrichtung nach Anspruch 9, dadurch gekennzeichnet, dass zwei Magnetfeldsonden (SO1, SO2) im wesentlichen symmetrisch zur Fahrzeuglängsachse (2) angeordnet sind.

11. Einrichtung nach Anspruch 10, dadurch gekennzeichnet, dass die beiden Magnetfeldsonden (SO1, SO2) in gleichem Abstand zur Fahrzeuglängsachse (2) angeordnet sind.

12. Einrichtung nach Anspruch 10, dadurch gekennzeichnet, dass die beiden Magnetfeldsonden hintereinander auf der Fahrzeuglängsachse (2) angeordnet sind.

## Revendications

1. Procédé de navigation à l'estime pour des véhicules routiers, selon lequel on mesure, à l'aide d'un dispositif à sonde le vecteur du champ magnétique terrestre et on l'évalue pour déterminer la direction respective de déplacement du véhicule, et selon lequel, pour compenser des influences perturbatrices de champs magnétiques parasites locaux dans le véhicule, on détermine au moyen de mesures d'étalonnage, un vecteur du champ parasite, on le mémorise et, lors des mesures effectuées ultérieurement, on le soustrait respectivement du vecteur mesuré du champ magnétique, afin d'obtenir le vecteur du champ terrestre, caractérisé en ce qu'on installe au moins deux sondes (SO1, SO2) de mesure du champ magnétique, séparées dans l'espace à l'intérieur du véhicule (1), on détermine et on mémorise pour ces sondes (SO1, SO2) des vecteurs propres respectifs ($\vec{s}_{11}$, $\vec{s}_{21}$) du champ parasite, que lors de chaque opération de mesure effectuée avec chaque sonde (SO1, SO2) de mesure du champ magnétique, on mesure un vecteur ($\vec{m}_1$, $\vec{m}_2$) du champ magnétique et on le corrige avec le vecteur associé ($\vec{s}_{11}$, $\vec{s}_{21}$) du champ parasite pour déterminer le vecteur ($\vec{e}_1$, $\vec{e}_2$) du champ terrestre, qu'on compare entre eux, du point de vue de la valeur et de la direction, les vecteurs ($\vec{e}_1$, $\vec{e}_2$) du champ terrestre, déterminés séparément, et qu'un signal de variation (as) est produit dans le cas d'un écart important réciproque des vecteurs déterminés du champ terrestre.

2. Procédé suivant la revendication 1, caractérisé par le fait qu'après l'obtention du signal de variation (as), on calcule de nouveaux vecteurs ($\vec{s}_{12}$, $\vec{s}_{22}$) du champ parasite sous la forme de différence entre les vecteurs ($\vec{m}_1$, $\vec{m}_2$) du champ magnétique nouvellement mesurés et le vecteur ($\vec{e}$) du champ terrestre déterminé en définitive comme étant coïncident.

3. Procédé suivant la revendication 2, caractérisé par le fait qu'on détermine la lecture du champ terrestre sur un intervalle de temps prédéterminé et/ou sur une section de trajet prédéterminée, en utilisant les vecteurs ($\vec{s}_{12}$, $\vec{s}_{22}$) du champ parasite nouvellement calculés.

4. Procédé selon la revendication 3, caractérisé en ce que, dans le cas où il apparaît un nouvel écart entre les vecteurs ($\vec{e}_1$, $\vec{e}_2$) du champ terrestre, déterminés à l'aide des vecteurs ($\vec{s}_{12}$, $\vec{s}_{22}$) du champ parasite nouvellement calculés, pour un instant déterminé, on exécute une correction des vecteurs mesurés du champ magnétique à l'aide des vecteurs initiaux ($\vec{s}_{11}$, $\vec{s}_{22}$) du champ parasite.

5. Procédé selon la revendication 3 ou 4, caractérisé en ce que dans le cas d'un nouvel écart entre les vecteurs du champ terrestre calculés en prenant pour base aussi bien les anciens vecteurs du champ parasite que les nouveaux vecteurs de ce champ ($\vec{s}_{11}$, $\vec{s}_{21}$; $\vec{s}_{12}$, $\vec{s}_{22}$), un dispositif indicateur (FA) est activé.

6. Procédé suivant l'une des revendications 1 à 5, caractérisé par le fait qu'on calcule et on mémorise à plusieurs reprises successivement de nouveaux vecteurs du champ parasite en utilisant des vecteurs du champ terrestre déterminés et mémorisés antérieurement et qu'on identifie et on évalue le type de variation du champ parasite à partir du modèle de comportement des vecteurs du champ parasite.

7. Procédé suivant l'une des revendications 1 à 4, caractérisé par le fait que pour la section de trajet parcourue pendant l'apparition d'un signal de variation (as), on prend pour base un vecteur moyen du champ terrestre que l'on détermine en tant que valeur moyenne à partir des vecteurs coïncidents ($\vec{e}_2$, $\vec{e}_2$) du champ terrestre, avant et après l'apparition du signal de variation.

8. Procédé suivant l'une des revendications 1 à 6, caractérisé par le fait que pour la section de trajet parcourue pendant l'apparition du signal de variation, on détermine un vecteur du champ terrestre par interpolation à partir des vecteurs du champ terrestre obtenus de façon coïncidente avant et après l'apparition du signal de variation.

9. Dispositif installé sur un véhicule pour la mise en œuvre du procédé suivant l'une des revendications 1 à 8, caractérisé par le fait que deux sondes (SO1, SO2) de détection du champ magnétique sont disposées dans le véhicule (1) en étant séparées dans l'espace, que les signaux de sortie des deux sondes (SO1, SO2) de mesure du champ magnétique sont envoyés, en commun avec les signaux de sortie de mémoires (SP11, SP21) de vecteurs du champ parasite, à des dispositifs respectifs (DI1, DI2) de formation de différences, dont les sorties, qui délivrent les vecteurs $(\vec{e}_1, \vec{e}_2)$ du champ terrestre, sont raccordées aux entrées d'un dispositif comparateur (VG).

10. Dispositif suivant la revendication 9, caractérisé par le fait que deux sondes (SO1, SO2) de mesure du champ magnétique sont disposées sensiblement symétriquement par rapport à l'axe longitudinal (2) du véhicule.

11. Dispositif suivant la revendication 10, caractérisé par le fait que les deux sondes (SO1, SO2) de mesure du champ magnétique sont disposées à une même distance de l'axe longitudinal (2) du véhicule.

12. Dispositif suivant la revendication 10, caractérisé par le fait que les deux sondes de mesure du champ magnétique sont disposées l'une derrière l'autre sur l'axe longitudinal (2) du véhicule.

**Claims**

1. A compound navigation method for road vehicles, in which method the field vector of the earth's magnetic field is measured by a probe arrangement and evaluated for determining the respective direction of movement of the vehicle, and in which an interference field vector is determined by calibration measurements, for compensating any interfering influence of local magnetic fields in the vehicle, to be stored and subtracted in each case from the measured magnetic field vector in the subsequent measurements to obtain the earth's field vector, characterised in that at least two magnetic field probes (SO1, SO2) are arranged spatially separate in the vehicle (1), that separate interference field vectors $(\vec{s}_{11}, \vec{s}_{21})$ are in each case determined and stored for these probes (SO1, SO2), that during each measuring process, a magnetic field vector $(\vec{m}_1, \vec{m}_2)$ is measured with each magnetic field probe (SO1, SO2) and corrected with the associated interference field vector $(\vec{s}_{11}, \vec{s}_{21})$ for determining the earth's field vector $(\vec{e}_1, \vec{e}_2)$, that the separately determined earth's field vectors $(\vec{e}_1, \vec{e}_2)$ are compared with one another with respect to magnitude and direction and that a change signal (as) is generated if the earth's field vectors thus determined deviate significantly from one another.

2. A method according to claim 1, characterised in that after the change signal (as) has been generated, new interference field vectors $(\vec{s}_{12}, \vec{s}_{22})$ are calculated as differences between the newly measured magnetic field vectors $(\vec{m}_1, \vec{m}_2)$ and the earth's field vector $(\vec{e})$ which has last been correspondingly determined.

3. A method according to claim 2, characterised in that the earth's field vector is determined over a predetermined time and/or a predetermined distance of travel, using the newly calculated interference field vectors $(\vec{s}_{12}, \vec{s}_{22})$.

4. A method according to claim 3, characterised in that, when any new divergence of the earth's field vectors $(\vec{e}_1, \vec{e}_2)$ determined with the aid of the newly calculated interference field vectors $(\vec{s}_{12}, \vec{s}_{22})$, a correction of the measured magnetic field vectors is carried out for a certain time with the aid of the original interference field vectors $(\vec{s}_{11}, \vec{s}_{21})$.

5. A method according to claim 3 or 4, characterised in that, when a new divergence of the earth's field vectors is calculated on the basis both of the old and of the new interference field vectors $(\vec{s}_{11}, \vec{s}_{21}; \vec{s}_{12}, \vec{s}_{22})$, a display device (FA) is actuated.

6. A method according to one of claims 1 to 5, characterised in that new interference field vectors are calculated and stored several times in succession, using previously determined and stored earth's field vectors, and that the type of interference field change is recognised from the pattern of behaviour of the interference field vectors and the evaluated.

7. A method according to one of claims 1 to 4, characterised in that a mean earth's field vector is used as a basis for the distance travelled during the occurrence of a change signal (as), which is determined as a mean value from the earth's field vectors $(\vec{e}_1, \vec{e}_2)$ exhibiting correspondence before and after the occurrence of the change signal.

8. A method according to one of claims 1 to 6, characterised in that an earth's field vector for the distance travelled during the occurrence of the change signal is determined by interpolation from the earth's field vectors correspondingly obtained before and after the occurrence of the change signal.

9. A device on a vehicle, for carrying out the method according to one of claims 1 to 8, characterised in that two magnetic field probes (SO1, SO2) are arranged spatially separate in the vehicle (1), that the output signals of the two magnetic field probes (SO1; SO2), together with the output signals of interference vector memories (SP11, SP21) are in each case supplied to a substractor (DI1, DI2) the outputs of which, which carry the earth's field vectors $(\vec{e}_1, \vec{e}_2)$, are connected to the inputs of a comparator device (VG).

10. A device according to claim 9, characterised in that two magnetic field probes (SO1, SO2) are arranged essentially symmetrical with respect to the longitudinal vehicle axis (2).

11. A device according to claim 10, characterised in that the two magnetic field probes (SO1, SO2) are arranged equally distant from the longitudinal vehicle axis (2).

12. A device according to claim 10, characterised in that the two magnetic field probes are arranged behind one another on the longitudinal vehicle axis (2).

FIG 1

FIG 3

FIG 2

FIG 4

# FIG 5

# FIG 6

3/3

FIG 7

FIG 8